# EUROPEAN PATENT APPLICATION

(11) **EP 2 500 943 A1**
(43) Date of publication of application: **19.09.2012**
(21) Application number: 10829997.5
(22) Date of filing: 11.11.2010
(51) Int. Cl.: H01L 27/146, G02F 1/136, H01L 27/06, H01L 27/12, H01L 31/10

(54) **SEMICONDUCTOR DEVICE AND METHOD FOR MANUFACTURING SAME**

(30) Priority: 13.11.2009 JP 2009260264
(71) Applicant: Sharp Kabushiki Kaisha, Osaka-shi, Osaka 545-8522 (JP)
(72) Inventor: KAIGAWA Hiroyuki, Osaka 545-8522 (JP)
(74) Representative: Müller - Hoffmann & Partner
(86) International application number: PCT/JP2010/070139
(87) International publication number: WO 2011/059038

(57) **Abstract**

This semiconductor device includes: a substrate; and a plurality of thin-film diodes which are supported by the substrate and electrically connected in parallel with each other. The thin-film diodes include at least one thin-film diode of a first type (**100A**), of which the semiconductor layer (**10A**) has an N-type region (**1A**), an intrinsic region (**5A**), and a P-type region **(3A)** that are arranged in this order in a first direction **X** within a plane that is parallel to the substrate, and at least one thin-film diode of a second type (**100B**), of which the semiconductor layer **(10B)** has a P-type region **(3B)**, an intrinsic region **(5B),** and an N-type region (**1B**) that are arranged in this order in the first direction **X**. With such a configuration adopted, the variation in photocurrent characteristic between the thin-film diodes can be reduced.

## Description

### TECHNICAL FIELD

The present invention relates to a semiconductor device including a thin-film diode and also relates to a method for fabricating such a device.

### BACKGROUND ART

Recently, display devices, image sensors and other electronic devices with a photosensor section that uses thin-film diodes (TFDs) have been developed. For example, Patent Document No. 1 discloses a technique for sensing a finger or any other object on the screen with external light by providing a photosensor section that uses TFDs for the display area of an LCD.

Examples of diodes for use as photosensors (i.e., photodiodes) include a PN diode and a PIN diode. Each of these diodes senses the light that irradiates the PN junction of a semiconductor layer, to which a reverse bias voltage is applied, by the flow of carriers (i.e., electrons or holes) that have been produced in a depletion layer through excitation. The PIN diode has a semiconductor region with relatively high electrical resistance (which is sometimes called an "intrinsic region" and sometimes called an "i-region") between P- and N-type regions. As a result, the depletion layer to be produced when a reverse bias voltage is applied thereto comes to have an increased width, and a high electric field generated in the depletion layer accelerates the flow of the carriers. Consequently, the PIN diode achieves a higher photosensitivity and a higher response speed than the PN diode does. It was also proposed that a gate electrode be arranged on the intrinsic region of the PIN diode and a gate voltage be applied thereto in order to reduce reverse dark current that flows through the intrinsic region. Such a PIN diode is called a "gate controlled type".

Generally speaking, in a photosensor that uses PIN diodes, the length **L** and width **W** of an intrinsic region to be its photosensitive region become important parameters that determine the sensitivity of the photosensor. In this description, the "length L of an intrinsic region" refers herein to the shortest distance between one end of the intrinsic region closer to the N-type region and the other end thereof closer to the P-type region, while the "width **W** of the intrinsic region" refers herein to the width of the intrinsic region as measured perpendicularly to that shortest distance. Among these parameters, the length **L** determines the potential gradient between the anode and cathode of the PIN diode and contributes to controlling the width of the depletion layer, and therefore, is a particularly important parameter.

In the PIN diode manufacturing process, a semiconductor layer is ordinarily implanted with ions of a dopant that gives a predetermined conductivity type to the semiconductor layer, thereby defining a P-type region and an N-type region. That is why the length L of the intrinsic region is determined by the arrangement of a resist mask that is used to dope the semiconductor layer with an n-type dopant and that of another resist mask that is used to dope the semiconductor layer with a p-type dopant. Each of these resist masks is defined by photolithographic process. That is to say, each resist mask is defined by performing the process steps of exposing a resist film to a radiation through a photomask and developing the resist mask that has been exposed to the radiation. In this description, the process step of defining a resist mask for use to introduce an n-type dopant and the process step of defining a resist mask for use to introduce a p-type dopant will be referred to herein as an "ND photo process step" and a "PD photo process step", respectively.

In the ND and PD photo process steps, the photomask could be misaligned with the semiconductor layer and the resist mask could be formed at a different position from the designed one. That is why if two different exposure systems are used to perform the ND and PD photo process steps, respectively, the length **L** will vary more significantly from one lot to another, and eventually, the output characteristic of the sensor will also vary noticeably from one product to another, which is a problem.

To avoid this problem, the same exposure system could be used in the ND and PD photo process steps. In that case, however, the exposure system would have halved productivity.

Thus, it has been difficult to realize stabilized photocurrent characteristic while maintaining high enough productivity and minimizing the variation in the length L of the PIN diodes at the same time.

On the other hand, Patent Document No. 2 discloses a gate controlled type PIN diode in which a gate electrode is arranged over an intrinsic region and in which the length of a portion of the intrinsic region that is not covered with the gate electrode is controlled by adjusting the width of the gate electrode.

FIG. **13** is a cross-sectional view illustrating the diode disclosed in Patent Document No. 2. The diode **1000** includes a substrate **909,** a semiconductor layer **910** that has been formed on the substrate **909**, a gate insulating film **908** that has been deposited over the semiconductor layer 9**10**, a gate electrode **905** that is arranged on the gate insulating film **908,** an anode electrode **914**, and a cathode electrode **915**. The semiconductor layer **910** includes a P-type region **903**, an N-type region **904** and first and second photosensitive regions **906** and **907**, which located are between those two regions **903** and **904.** The gate electrode **905** overlaps with the first photosensitive area **906** with the gate insulating film **908** interposed between them. The anode electrode **914** is connected to the P-type region **903** and the cathode electrode **915** is connected to the N-type region **904**.

Patent Document No. 2 says that by adjusting the width of the gate electrode **905**, the length **L2** of the second photosensitive region **907** can be controlled, and therefore, a variation in photocurrent value can be reduced.

### CITATION LIST

### PATENT LITERATURE

Patent Document No. 1: WO 2008/132862
Patent Document No. 2: Japanese Laid-Open Patent Publication No. 2006-332287

### SUMMARY OF INVENTION

### TECHNICAL PROBLEM

In the diode disclosed in Patent Document No. 2 (see FIG. **13**), the gate electrode **905** needs to be provided in order to adjust the length of the second photosensitive region **907.** That is why the overall size of the diode increases by the length **L1** of the gate electrode **905**, which is a problem. Also, when the gate electrode **905** is formed by patterning a metal film by dry etching, the semiconductor layer **910** of the diode may get damaged by the etching process. In that case, such an etch-damaged portion can be a site of recombination, and therefore, it will be difficult to achieve an even higher SNR. On top of that, the light reflected from the gate electrode **905** and the light incident on the second photosensitive region **907** of the semiconductor layer **910** may interfere with each other and the quantity of light entering the semiconductor layer **910** may decrease.

Consequently, according to the configuration disclosed in Patent Document No. 2, it is difficult to reduce the variation in photocurrent characteristic while ensuring high photosensitivity (or SNR) and minimizing an increase in the overall size of the diode.

It is therefore an object of the present invention to reduce such a variation in the photocurrent characteristic of a semiconductor device with a PIN diode without decreasing the productivity.

### SOLUTION TO PROBLEM

A semiconductor device according to the present invention includes: a substrate; and a plurality of thin-film diodes which are supported by the substrate and electrically connected in parallel with each other and each of which includes a semiconductor layer that has a P-type region, an N-type region, and an intrinsic region arranged between the P- and N-type regions. The thin-film diodes include at least one thin-film diode of a first type, of which the semiconductor layer has the N-type region, the intrinsic region, and the P-type region that are arranged in this order in a first direction within a plane that is parallel to the substrate, and at least one thin-film diode of a second type, of which the semiconductor layer has the P-type region, the intrinsic region, and the N-type region that are arranged in this order in the first direction.

In one preferred embodiment, the semiconductor layer of at least one of the thin-film diodes is arranged adjacent to the semiconductor layer of another thin-film diode of a different type, and either the respective N-type regions or the respective P-type regions of the semiconductor layers of the at least one thin-film diode and that another thin-film diode face each other.

In one preferred embodiment, the thin-film diodes include 2n thin-film diodes (where n is a positive integer). n of those 2n thin-film diodes are the first type of thin-film diodes, and the other n thin-film diodes have the semiconductor layer of the second type of thin-film diodes.

In one preferred embodiment, the respective semiconductor layers of the 2n thin-film diodes are arranged so that either the respective N-type regions or the respective P-type regions of two adjacent one of the semiconductor layers face each other.

None of the thin-film diodes need to have a gate electrode.

A semiconductor device fabricating method according to the present invention is a method for fabricating a semiconductor device according to any of the preferred embodiments of the present invention described above. The method includes the steps of: forming a plurality of semiconductor layers as semiconductor islands on the substrate; defining a first resist mask so that the first resist mask covers portions of each said semiconductor island to be N-type and intrinsic regions but exposes the other portion of the semiconductor island to be a P-type region, and implanting ions of a P-type dopant into that portion of each said semiconductor island that is not covered with the first resist mask, thereby defining a P-type region there; and defining a second resist mask so that the second resist mask covers portions of each said semiconductor island to be P-type and intrinsic regions but exposes the other portion of the semiconductor island to be an N-type region, and implanting ions of an N-type dopant into that portion of each said semiconductor island that is not covered with the second resist mask, thereby defining an N-type region there. The region of each said semiconductor island that is located between the N- and P-type regions becomes an intrinsic region.

### ADVANTAGEOUS EFFECTS OF INVENTION

According to the present invention, a semiconductor device with multiple PIN diodes can have less varied photocurrent characteristic without decreasing its productivity.

### BRIEF DESCRIPTION OF DRAWINGS

[FIG. **1**] A schematic plan view illustrating two thin-film diodes in a semiconductor device as a first embodiment of the present invention.
[FIG. **2**] A plan view illustrating two thin-film diodes in a semiconductor device as a comparative example.
[FIG. **3**] **(a)** through **(f)** are plan views illustrating alternative arrangements for thin-film diode according to the first embodiment.
[FIG. **4**] A view illustrating the configuration of a touchscreen panel as a semiconductor device according to a second embodiment of the present invention.
[FIG. **5**] A schematic plan view illustrating the rear substrate of the touchscreen panel type liquid crystal display device as the second embodiment of the present invention.
[FIG. **6**] **(a)** and **6(b)** are respectively a circuit diagram and a plan view illustrating a configuration for a photosensor section according to the second embodiment of the present invention.
[FIG. **7****] (a)** is a plan view illustrating a manufacturing process step to fabricate the semiconductor device of the second embodiment and **(b)** is a partial cross-sectional view of **(a).**
[FIG. **8**] **(a)** is a plan view illustrating another manufacturing process step to fabricate the semiconductor device of the second embodiment and **(b)** is a partial cross-sectional view of **(a)** as viewed on the plane **A-B**.
[FIG. **9****] (a)** is a plan view illustrating another manufacturing process step to fabricate the semiconductor device of the second embodiment and **(b)** is a partial cross-sectional view of (**a)** as viewed on the plane **A-B**.
[FIG. **10****] (a)** is a plan view illustrating another manufacturing process step to fabricate the semiconductor device of the second embodiment and **(b)** is a partial cross-sectional view of **(a)** as viewed on the plane **A-B.**
[FIG. **11**] **(a)** is a plan view illustrating another manufacturing process step to fabricate the semiconductor device of the second embodiment and **(b)** is a partial cross-sectional view of **(a)** as viewed on the plane **A-B.**
[FIG. **12****] (a)** is a plan view illustrating another manufacturing process step to fabricate the semiconductor device of the second embodiment and **(b)** is a partial cross-sectional view of **(a)** as viewed on the plane **A-B.**
[FIG. **13**] A cross-sectional view illustrating a known thin-film diode.
[FIG. **14**] **(a)** through **(e)** are cross-sectional views illustrating respective manufacturing process steps to fabricate a semiconductor device including thin-film diodes as a reference example.
[FIG. **15**] **(a)** through **(d)** are cross-sectional views illustrating respective manufacturing process steps to fabricate a semiconductor device including thin-film diodes as a reference example.
[FIG. **16**] A graph showing how the length L of each diode changes with the photocurrent value.

### DESCRIPTION OF EMBODIMENTS

As described above, in the known PIN diode, the photomask and the surface of the substrate may be misaligned with each other in the ND and PD photo process steps and the length **L** of its intrinsic region will vary, which is a problem. Hereinafter, it will be described in detail how that problem arises during the manufacturing process of a semiconductor device with a PIN diode as an example.

In a semiconductor device such as the active-matrix substrate of a touchscreen panel type display device, an N-channel TFT, a P-channel TFT and a photodiode need to be fabricated on the same substrate. To fabricate such a semiconductor device efficiently, it is beneficial to perform the process step of defining an N-type region in the photodiode and the process step of defining source/drain regions in the N-channel TFT at the same time. Likewise, the process step of defining a P-type region in the photodiode and the process step of defining source/drain regions in the P-channel TFT had better be performed at the same time. According to a result of the research the present inventors carried out, the manufacturing process of such a semiconductor device may be as follows:

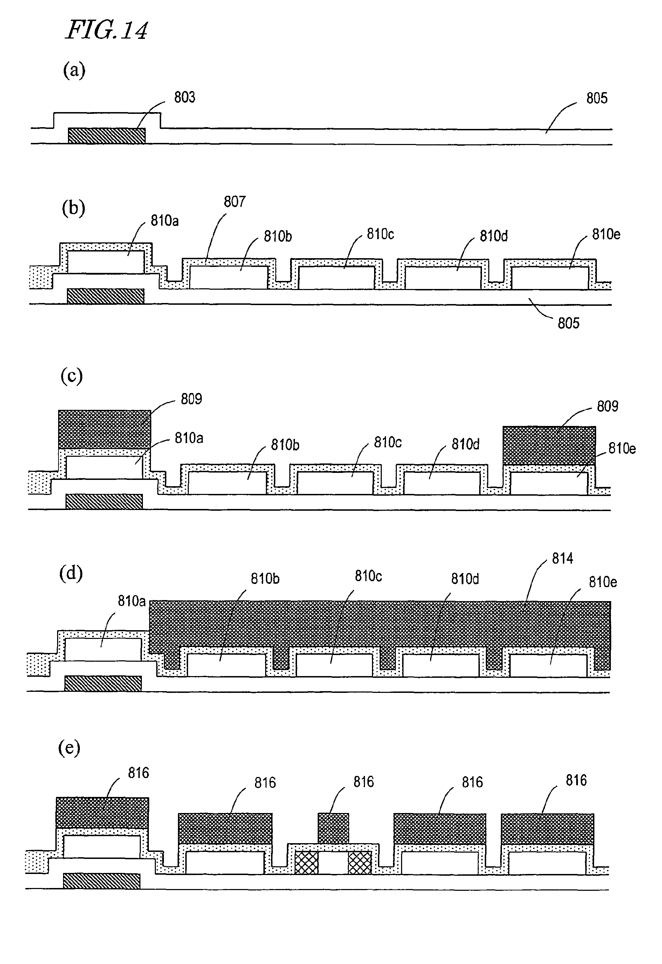

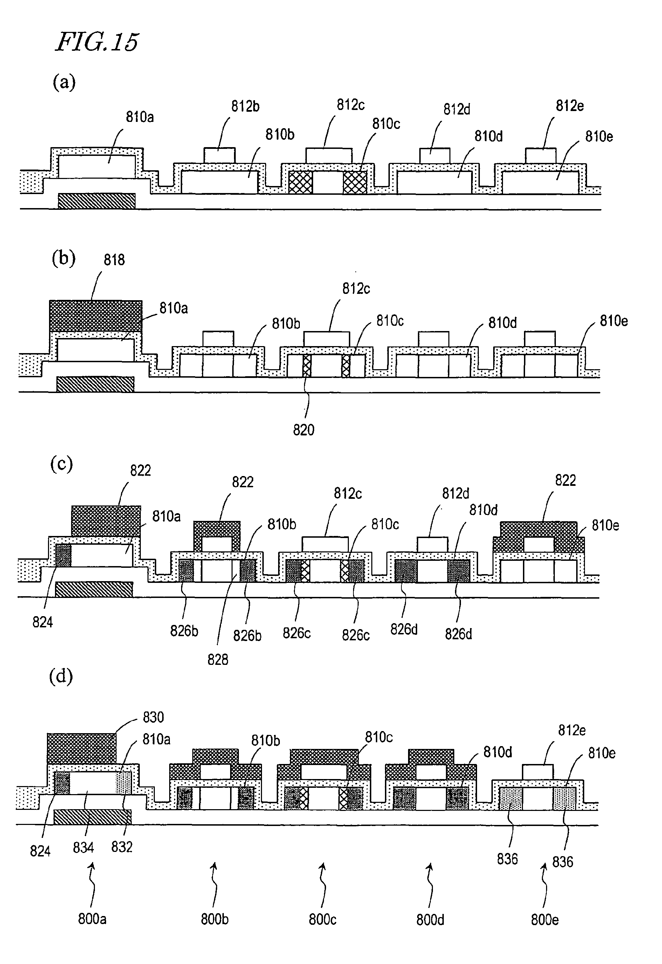

FIGS. **14** and **15** illustrate cross-sectional views showing respective manufacturing process steps to fabricate a semiconductor device. The process illustrated in FIGS. **14** and **15** will be referred to herein as a "reference example".

First of all, as shown in FIG. **14(a)**, an opaque layer **803** for a photodiode is formed on a substrate (not shown) and then an insulating film **805** is deposited over the entire surface of the substrate.

Thereafter, as shown in FIG. **14(b)**, semiconductor layers **810a, 810b, 810c, 810d** and **810e** to be the respective active layers of the photodiode, an N-channel TFT with an LDD structure, an N-channel TFT with a GOLD structure, an N-channel TFT with a single drain structure, and a P-channel TFT are formed on the insulating film **805**. These semiconductor layers **810a** through **810e** are obtained by patterning the same semiconductor film (e.g., a polysilicon film in this example). Subsequently, a gate insulating film **807** is deposited over all of these semiconductor layers **810a** through **810e.**

Next, ions of a P-type dopant (such as boron) are lightly implanted into the entire surface of the substrate from over the gate insulating film **807.**

Subsequently, a resist mask **809** is defined so as to cover the semiconductor layers **810a** and **810e** but expose the semiconductor layers **810b** through **810d** as shown in FIG. **14(c)****.** In such a state, ions of a P-type dopant (such as boron) are lightly implanted into those semiconductor layers **810b, 810c** and **810d** to be the respective active layers of N-channel TFTs (i.e., a so-called "channel doping process" is carried out).

Thereafter, as shown in FIG. **14(d)**, another resist mask **814** is defined so as to cover the semiconductor layers **810b** through **810e** but expose only the semiconductor layer **810a.** In such a state, ions of a P-type dopant (such as boron) are lightly implanted into just the semiconductor layer **810a.** In this manner, the resistance in the intrinsic region of the semiconductor layer **810a** of the diode can be adjusted.

Next, still another resist mask **816** is defined so as to cover the semiconductor layers **810a, 810b, 810d,** and **810e** but partially expose the semiconductor layer **810c** as shown in FIG. **14(e)**. In such a state, ions of an N-type dopant (such as phosphorus) are lightly implanted into only the semiconductor layer **810c.**

Subsequently, as shown in FIG. **15(a)****,** gate electrodes **812b** through **812e** are formed so as to cover respective channel regions to be of the semiconductor layers **810b** through **810e** to be the respective active layers of TFTs. Those gate electrodes **812b** through **812e** can be formed by depositing a metal film over the entire surface of the substrate and then patterning the metal film.

Thereafter, yet another resist mask **818** is defined so as to cover only the semiconductor layer **810a** but expose the other semiconductor layers **810b** through **810e** as shown in FIG. **15(b)**. In such a state, ions of an N-type dopant (such as phosphorus) are lightly implanted into the semiconductor layers **810b** through **810e**. Portions **820** of the semiconductor layer **810c,** to which phosphorus ions have been implanted in the process step shown in FIG. **15(a)** but have not in this process step due to the presence of the gate electrode **812c,** become GOLD regions.

Subsequently, as shown in FIG. **15(c)**, yet another resist mask **822** is defined so as to cover a part of the semiconductor layer **810a,** a part of the semiconductor layer **810b,** and all of the semiconductor layer **810e.** In this process step, the gate electrode pattern can be used as an alignment pattern for positioning the photomask properly. Next, ions of an N-type dopant (such as phosphorus) are heavily implanted into respective portions of the semiconductor layers **810a** and **810b** that are not covered with the resist mask **822** and into respective portions of the semiconductor layers **810c** and **810d** that are not hidden behind the gate electrodes **812c** and **812d.** That is to say, the ND photo process step is carried out. As a result, an N-type region **824** is defined in the semiconductor layer **810a** and source/drain regions **826b** through **826d** are defined in the semiconductor layers **810b** through **810d***,* respectively. Portions **828** of the semiconductor layer **810b,** to which phosphorus ions have been implanted in the process step shown in FIG. **15(b)** but have not in this process step due to the presence of the resist mask **822**, become LDD regions.

Thereafter, as shown in FIG. **15(d)****,** yet another resist mask **830** is defined so as to cover a part of the semiconductor layer **810a** and all of the semiconductor layers **810b** through **810d.** In this process step, the gate electrode pattern can be used as an alignment pattern for positioning the photomask properly. Next, ions of a P-type dopant (such as boron) are heavily implanted into a portion of the semiconductor layer **810a** that is not covered with the resist mask **830** and into a portion of the semiconductor layer **810e** that is not hidden behind the gate electrode **812e.** That is to say, the PD photo process step is carried out. As a result, a P-type region **832** is defined in the semiconductor layer **810a** and source/drain regions **836** are defined in the semiconductor layer **810e.** The rest of the semiconductor layer **810a** located between the P- and N-type regions **832** and **824** becomes an intrinsic region. After that, although not shown, the resist mask **830** is removed. In this manner, a photodiode **800a**, N-channel **TFTs 800b** through **800d** and a P-channel TFT **800e** can be fabricated on the substrate **810.**

According to the method described above, the length **L** of the intrinsic region **834** of the photodiode **800a** is defined by the shapes of the photomasks (not shown) for use in the photo process steps to define the resist masks **822** and **830** shown in FIGS. **15 (c)** and **15 (d)** . Such a length **L** that is defined by the shapes of the photomasks will be referred to herein as a "designed value **L**₀".

As will be described later, misalignment or dimensional error could be caused in the photo process step. In this description, the "misalignment" refers herein to a positional error between a photomask and the surface of the substrate, and the magnitude of the error depends on the alignment accuracy of an exposure system (or stepper) to use. Meanwhile, depending on the condition of the exposure or the development process, the photomask pattern and the resist mask 822 actually defined may have openings or opaque portions in slightly different shapes. Such an error will be referred to herein as a "dimensional error". If there is such misalignment or dimensional error, the length **L** of the diode becomes greater or smaller than the designed value **L**₀.

The present inventors actually made sample diodes through the ND and PD photo process steps to see how much the lengths **L** varied. An example of the results is shown in the following Table 1:

**Table 1**

| | | | Actual performance | |
|---|---|---|---|---|
| Sensor length L variation factor | Process | Variation factor | Variation from lower layer in photo process steps | |
| | | | Known process using different exposure systems for ND and PD photo steps | Process using same exposure system for ND and PD photo steps |
| ND photo process step | Exposure | Dimensional error: a (*µ*m) | 0.3 | 0.3 |
| | | Misalignment: b (*µ*m) | 0.8 | - |
| PD photo process step | Exposure | Dimensional error: a' (*µ*m) | 0.3 | 0.3 |
| | | Misalignment: b' (*µ*m) | 0.8 | - |
| ((a)²+(b)²+(a')²+(b')²)^{1/2} | | | 1.2 | 0.4 |

In the ND photo process step, the alignment pattern (e.g., the gate electrode pattern) that has been defined on the surface of the substrate and a photomask (not shown) need to be aligned with each other. In this process step, the magnitude of error due to misalignment may be approximately 0.8 *µ*m, for example, even though it depends on the alignment accuracy of the exposure system to use. On the other hand, the magnitude of the dimensional error may be approximately 0.3 *µ*m, which is smaller than the magnitude of error due to misalignment. Likewise, in the PD photo process step, a dimensional error of approximately 0.3 *µ*m and a misalignment of approximately 0.8 *µ*m, for example, may also be caused. Consequently, the variation in the length L of the intrinsic region of the diode calculates to be approximately 1.2 *µ*m.

On the other hand, if the same exposure system is used in both of the ND and PD photo process steps, then the misalignment of the same magnitude (i.e., a positional error of the same magnitude) will be caused in the same direction. That is why the length L will be constant irrespective of the alignment accuracy. Consequently, in that case, the variation in length **L** will be solely due to the dimensional error in those photo process steps. As a result, the variation in length **L** caused by the ND and PD photo process steps can be reduced to about 0.4 *µ*m, for example. Nevertheless, if the same exposure system is used in those two photo process steps, the productivity of the exposure system will decline to a half, thus causing an increase in overall cost.

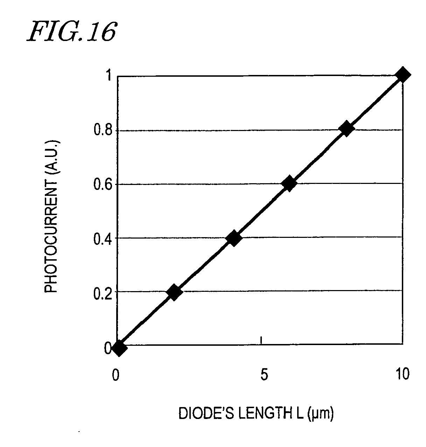

FIG. **16** is a graph showing how the length L of the intrinsic region of each diode changes with the photocurrent value. As shown in FIG. **16**, if the length **L** is equal to or smaller than a particular value, the photocurrent value is proportional to the length **L**. As shown in Table 1, if the ND and PD photo process steps are carried out using mutually different exposure systems, the variation in length **L** will be 1 *µ*m or more. It can be seen that if the length **L** varied by as much as 1 *µ*m or more, the photocurrent characteristic also varied so significantly as to debase the quality seriously.

As can be seen, according to the current state of the art, it has been difficult to stabilize the photocurrent characteristic while ensuring high enough productivity and minimizing the variation in the length L of the photodiode.

Thus, to minimize such a variation in the length **L** of the photodiode, the present inventors carried out researches from various angles. As a result, we discovered that if two diodes are connected in parallel with each other and are arranged so that the P- and N-type regions that interpose an intrinsic region between them are arranged in reverse order in the respective semiconductor layers of those two diodes, the variation in the photocurrent characteristic due to the misalignment can be reduced significantly.

In a photosensor comprised of multiple diodes that are connected in parallel with each other, the length of the intrinsic region of each of those diodes becomes an important parameter that determines the photocurrent characteristic (i.e., the photosensitivity) of the photosensor. Although the length of the intrinsic region will vary from one diode to another due to misalignment, such a variation in the length of the intrinsic region can be canceled according to the present invention by arranging the respective semiconductor layers of the two diodes as described above.

Specifically, supposing the designed value of the intrinsic region's length is Lo and the magnitude of variation from the designed value Lo due to misalignment is Δx, the intrinsic region of one of the two diodes that are connected in parallel with each other has a length Lo+Δx and that of the other diode has a length Lo-Δx. In this case, the length **L** of the intrinsic region is proportional to the photocurrent value as shown in FIG. **16****.** That is why even if the photocurrent value of one diode increases, that of the other diode decreases accordingly. Consequently, in spite of misalignment, the variation in the photocurrent characteristic of the photosensor can be reduced compared to known ones.

### (EMBODIMENT 1)

Hereinafter, a first embodiment of a semiconductor device according to the present invention will be described. The semiconductor device of this embodiment includes multiple diodes that have been fabricated on a substrate and that are electrically connected in parallel with each other.

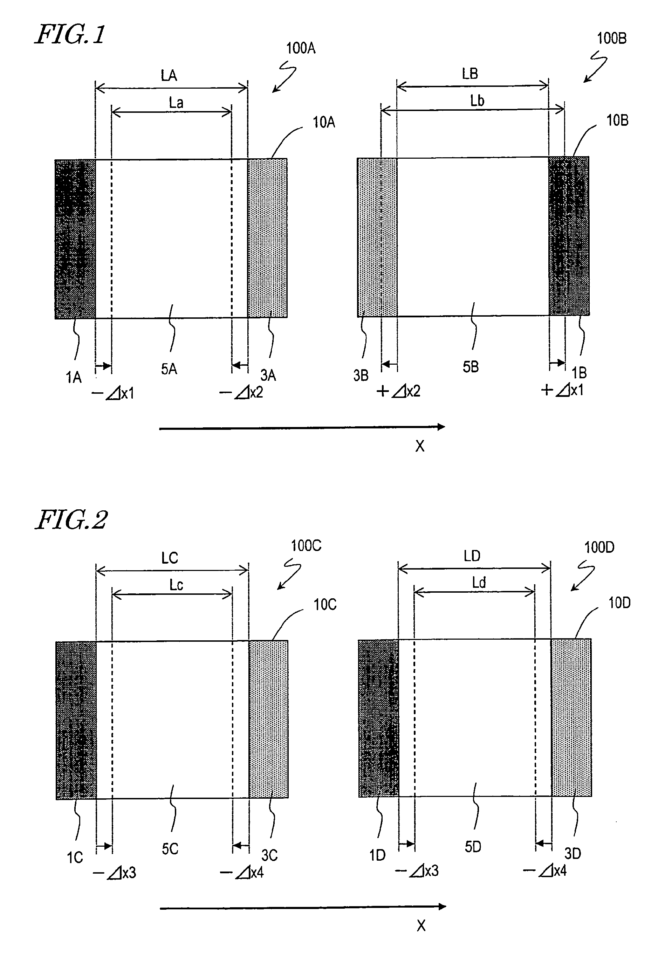

FIG. **1** is a schematic plan view illustrating two thin-film diodes **100A** and **100B** in a semiconductor device according to this embodiment. Optionally, the semiconductor device of this embodiment may include three or more thin-film diodes or any other kind of semiconductor element such as a TFT on the same substrate.

The thin-film diode **100A** of this embodiment includes a semiconductor island **10A** comprised of an N-type region 1A**,** a P-type region **3A** and an intrinsic region **5A** that is located between those two regions **1A** and **3A**. Likewise, the thin-film diode **100B** also includes a semiconductor island **10B** comprised of an N-type region **1B**, a P-type region **3**B and an intrinsic region **5B** that is located between those two regions **1B** and **3B.** In this description, the region that is interposed between P-and N-type regions and that has a lower dopant concentration (i.e., has higher resistance) than any of those two regions will be referred to herein as an "intrinsic region". That is why the intrinsic region may be a either a region made of an intrinsic semiconductor or a region lightly doped with a P- or N-type dopant. Also, the designed values of the respective lengths **L** of the intrinsic regions **5A** and **5B** of the thin-film diodes **100A** and 100B will be referred to herein as "length **LA"** and "length **LB**", respectively.

Although not shown, these two thin-film diodes **100A** and **100B** are connected in parallel with each other. That is to say, the N-type regions **1A** and **1B** are connected together, so are the P-type regions **3A** and **3B**.

The semiconductor layers **10A** and **10B** are arranged so that the length direction of their intrinsic regions **5A** and **5B** becomes parallel to a particular direction **X** on the surface of the substrate (not shown). That is to say, the semiconductor layer **10A** includes the N-type region **1A,** the intrinsic region **5A** and the P-type region **3A** that are arranged in this order in the X direction. On the other hand, the semiconductor layer **10B** includes the P-type region **3B,** the intrinsic region **5B** and the N-type region **1B** that are arranged in this order in the X direction. That is to say, in these two semiconductor layers **10A** and **10B**, the P- and N-type regions that interpose the intrinsic region between them are arranged in reverse order. Consequently, even if misalignment occurs in the process step of forming an implant mask to define the N-type regions **1A** and **1B** (i.e., in the ND photo process step) or in the process step of forming an implant mask to define the P-type regions **3A** and 3B (i.e., in the PD photo process step), the variation in the photocurrent characteristic of a photosensor including these diodes **100A** and **100B** due to the misalignment can be reduced significantly.

For example, suppose a misalignment of Δ x1 has occurred in the X direction in the ND photo process step and a misalignment of -Δx2 has occurred in the X direction in the PD photo process step. In that case, the length **La** of the intrinsic region **5A** of the semiconductor layer **10A** becomes LA+ (-Δx1)+(-Δx2), which is smaller than LA. On the other hand, the length **Lb** of the intrinsic region **5B** of the semiconductor layer **10B** becomes LB + Δx1 + Δx2, which is larger than LB. In this manner, the variation in the length **La** from its designed value **LA** and the variation in the length **Lb** from its designed value **LB** cancel each other between these two intrinsic regions **5A** and **5B.** As a result, even though the photocurrent value of the thin-film diode **100A** becomes smaller than the designed value, the photocurrent value of the thin-film diode **100B** becomes larger than the designed value accordingly. Consequently, the variations in photocurrent value due to the misalignment can cancel each other.

In this manner, the variation in photocurrent value due to misalignment can be substantially eliminated. That is why the photocurrent value will vary only because of a variation in the length of the intrinsic region due to a dimensional error described above, and therefore, the variation in photocurrent value can be reduced significantly. Consequently, the photocurrent characteristic of a photosensor including these thin-film diodes **100A** and **100B** can be stabilized.

For the purpose of comparison, it will be described what about the lengths of the intrinsic regions of a semiconductor device having thin-film diodes in which the regions are arranged in the same order. Such a semiconductor device will be referred to herein as a "comparative example".

FIG. **2** is a plan view illustrating the respective semiconductor layers **10C** and **10D** of the thin-film diodes **100C** and **100D** of the comparative example. In this comparative example, the semiconductor layer **10C** includes an N-type region **1C**, an intrinsic region **5C** and a P-type region **3C,** which are arranged in this order in the X direction. Likewise, the semiconductor layer **10D** also includes an N-type region **1D,** an intrinsic region **5D** and a P-type region **3D**, which are arranged in this order in the X direction. The designed values of the respective lengths of the intrinsic regions **5C** and **5D** of the semiconductor layers **10C** and **10D** will be identified herein by LC and LD, respectively.

For example, suppose a misalignment of Δ x3 has occurred in the X direction in the ND photo process step and a misalignment of -Δ x4 has occurred in the X direction in the PD photo process step. In that case, the length **Lc** of the intrinsic region **5C** of the semiconductor layer **10C** becomes LC+ (-Δx3)+(-Δx4), which is smaller than LC. On the other hand, the length Ld of the intrinsic region **5D** of the semiconductor layer **10D** becomes LD + (-Δx3) + (-Δx4), which is smaller than LD. Thus, the respective lengths of the intrinsic regions **5C** and **5D** both become much smaller than the designed values **LC** and **LD,** respectively. As a result, both of these thin-film diodes **100C** and **100D** come to have smaller photocurrent values than the designed ones. Consequently, the photocurrent characteristic of a photosensor including such diodes **100C** and **100D** deteriorates considerably, and eventually, the photosensitivity might decrease significantly.

In the example illustrated in FIG. **1**, only two thin-film diodes **100A** and **100B** are connected in parallel with each other. However, three or more thin-film diodes may be connected in parallel with each other as well. In that case, the effect described above can also be achieved as long as the P- and N-type regions are arranged in reverse order with respect to the intrinsic region in the respective semiconductor layers of at least two of those thin-film diodes.

In this description, a thin-film diode, of which the semiconductor layer includes an N-type region, an intrinsic region and a P-type region that are arranged in this order in the direction **X,** will be referred to herein as a "first type of TFD". Meanwhile, a thin-film diode, of which the semiconductor layer includes a P-type region, an intrinsic region and an N-type region that are arranged in this order in the direction **X,** will be referred to herein as a "second type of TFD" for the sake of simplicity. In this embodiment, the thin-film diodes **100A** and **100B** are a first type of TFD and a second type of TFD, respectively.

In the example illustrated in FIG. **1**, the respective semiconductor layers **10A** and **10B** of the first and second types of TFDs are arranged adjacent to each other. However, these semiconductor layers **10A** and **10B** just need to be arranged in a predetermined direction **X** on the same substrate and do not have to be arranged adjacent to each other. For example, there may be another semiconductor layer between those semiconductor layers **10A** and **10B** of the first and second types of TFDs.

According to this embodiment, a plurality of thin-film diodes, including the first and second types of TFDs that are connected in parallel with each other, just needs to be arranged on the substrate. If at least one TFD of the first type and at least one TFD of the second type are included, then the variation in photocurrent value due to misalignment can be reduced, and therefore, the effect described above can be achieved, too.

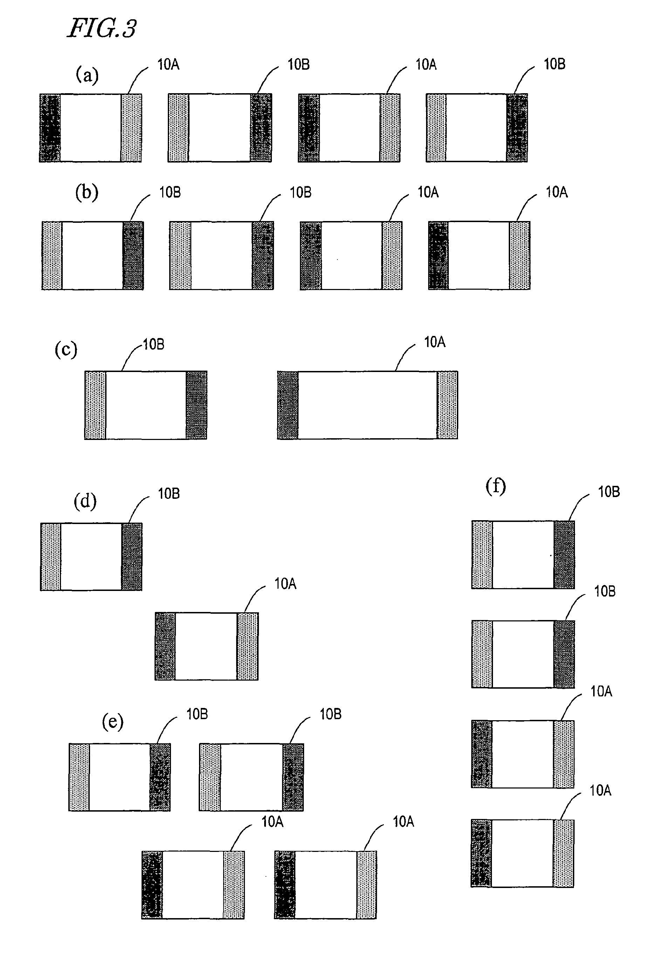

As for the arrangement and number of the thin-film diodes, the example shown in FIG. **1** does not always have to be followed. FIGS. **3(a)** through **3(f)** are schematic plan views illustrating alternative arrangements for the thin-film diode according to this embodiment. Although not shown in any of these drawings, thin-film diodes are connected in parallel with each other and together function as a single photosensor diode. Furthermore, the number of the thin-film diodes to use does not have to be the illustrated one but may be selected appropriately.

In the example illustrated in FIG. **3(a)****,** the semiconductor layers **10A** and **10B** of the first and second types of TFDs are alternately arranged in line. In the example illustrated in FIG. **3(a)****,** two TFDs of the first type and two TFDs of the second type are shown. However, the number of thin-film diodes to use does not have to be four but may also be three, five or more.

On the other hand, in the example illustrated in FIG. **3(b)****,** four semiconductor layers are arranged in line so that the semiconductor layers **10B** of two TFDs of the second type are adjacent to each other and that the semiconductor layers **10A** of two TFDs of the first type are adjacent to each other.

Optionally, the respective semiconductor layers **10A** and **10B** may have mutually different shapes or intrinsic regions with different lengths (designed values). For example, the semiconductor device may also be designed so that the intrinsic region of one semiconductor layer is longer than that of the other semiconductor layer as shown in FIG. **3(c)****.** Even so, as long as the lengths of the respective intrinsic regions (including their variations) are determined so as to be proportional to the photocurrent values, the variations in photocurrent values from the designed values can cancel each other between these diodes. As a result, the effect described above can also be achieved.

The widths of the respective intrinsic regions of the semiconductor layers **10A** and **10B** as measured perpendicularly to the direction **X** may be equal to each other. In that case, the variation in photocurrent value due to misalignment can be reduced even more effectively.

In the examples illustrated in FIGS. **3(a)** to **3(c)****,** at least one pair of semiconductor layers **10A** and **10B** of mutually different types are arranged so that either their N-type regions or their P-type regions face each other. Also, the semiconductor layers **10A** and **10B** are arranged in line in the X direction. According to such an arrangement, an elongate photosensor that runs in the X direction can be obtained. Such a photosensor can be used effectively in the active-matrix substrate of a touchscreen panel type display device, for example.

It should be noted that the semiconductor layers **10A** and **10B** just need to be arranged within a surface region of the substrate to be subjected to an exposure process using the same photomask. For instances, as in the examples illustrated in FIG. **3(d)** through **3(f)****,** the semiconductor layers **10A** and **10B** may also be arranged so that their N-type regions or P-type regions do not face each other.

According to this embodiment, the number of thin-film diodes to use is not particularly limited but may be an even number or an odd number. Nevertheless, the variation in photocurrent value due to misalignment can be compensated for more effectively if an even number 2n (where n is a positive integer) of thin-film diodes are connected in parallel with each other and consist of n TFDs of the first type and n TFDs of the second type. For that reason, it would be beneficial to adopt such an arrangement.

Hereinafter, it will be described how to fabricate the semiconductor device of this embodiment.

The manufacturing process of the semiconductor device of this embodiment includes the process steps of forming semiconductor layers **10A** and **10B** as semiconductor islands on a substrate, implanting an N-type dopant into the respective semiconductor layers **10A** and **10B** to define N-type regions there (i.e., the ND photo process step), and implanting a P-type dopant into the respective semiconductor layers **10A** and **10B** to define P-type regions there (i.e., the PD photo process step). These ND and PD photo process steps are performed by known photolithography. In each of those semiconductor layers, the region interposed between the N- and P-type regions becomes an intrinsic region. That is why the length of the intrinsic region is defined by the distance between the N- and P-type regions in each of those semiconductor layers **10A** and **10B.**

The ND and PD photo process steps are carried out using two different exposure systems. According to the known process, in order to reduce the variation in the length **L** of the intrinsic region among thin-film diodes, the same exposure system needs to be used in both the ND and PD photo process steps. In that case, however, the same substrate will have to be processed twice by the same exposure system. That is why the productivity will be limited by that exposure process and will decline to a half. On the other hand, since two different exposure systems are used according to this embodiment, the productivity can be kept sufficiently high and the rise in manufacturing cost can be avoided. On top of that, the misalignment to be caused by using two different exposure systems can be canceled between the semiconductor layers **10A** and **10B**. Consequently, the variation in photocurrent characteristic can be reduced to approximately the same degree (i.e., within the range of the variation involved with the dimensional accuracy) as in a situation where the same exposure system is used.

In this embodiment, each thin-film diode could further include a gate electrode that is arranged to overlap with the intrinsic region. Nevertheless, the thin-film diode had better have no gate electrodes. The reason is that with no gate electrodes provided, the semiconductor layer of the thin-film diode would not get damaged during a patterning process to form a gate electrode. In addition, since no gate electrode will interfere with the light incident on the thin-film diode in that case, the quantity of the incident light will not decrease due to the presence of a gate electrode.

If a gate electrode were arranged on the semiconductor layer so as to partially hide the intrinsic region (i.e., if a top-gate structure was adopted), only the rest of the intrinsic region that is not hidden behind the gate electrode would be a photosensitive region. In that case, the photosensitivity of the diode would depend on not only the length of the intrinsic region but also the width of the gate electrode as well. Even in such a situation, the variation in photocurrent characteristic due to the variation in the length of the photosensitive region can also be reduced by applying the present invention. Optionally, the gate electrode may also be used as an implant mask in one of the ND and PD photo process steps. Even so, the length of each photosensitive region, which is defined by the position of the resist mask to be formed by the other photo process step and by the position of the gate electrode, will also vary due to the misalignment caused in that other photo process step. Nevertheless, the misalignment can be canceled between the two diodes of mutually different types, and therefore, the photocurrent characteristic can be stabilized as well.

Optionally, the semiconductor device of this embodiment may further include a thin-film transistor on the same substrate on which the thin-film diodes **100A** and **100B** are provided. In that case, the ND photo process step to define the N-type regions for the thin-film diodes **100A** and **100B** and an ND photo process step to define source/drain regions for an N-channel thin-film transistor may be carried out at the same time. Likewise, the PD photo process step to define the P-type regions for the thin-film diodes **100A** and **100B** and a PD photo process step to define source/drain regions for a P-channel thin-film transistor may also be carried out at the same time. By performing the same process as what has already been described with reference to FIGS. **14** and **15**, the first and second types of TFDs and a thin-film transistor can be fabricated on the same substrate.

### (EMBODIMENT 2)

Hereinafter, a second embodiment of a semiconductor device according to the present invention will be described. The semiconductor device of this embodiment is a display device with a photosensor section including multiple thin-film diodes. In the following example, a configuration for a display device according to this embodiment will be described as being applied to a touchscreen panel LCD with a touchscreen panel sensor.

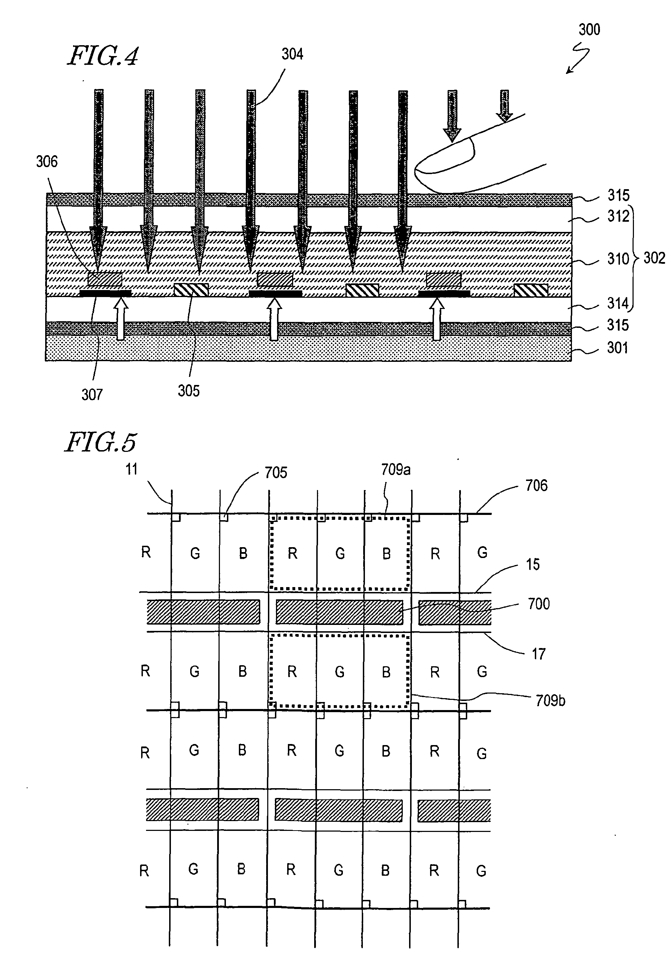

FIG. 4 is a schematic cross-sectional view illustrating an example of an active-matrix-addressed touchscreen panel LCD.

The LCD 300 includes a liquid crystal module 302 and a backlight 301, which is arranged behind the liquid crystal module 302. The liquid crystal module 302 includes a light transmissive rear substrate 314, a front substrate 312 that is arranged to face the rear substrate **314**, and a liquid crystal layer **310** interposed between those two substrates. The liquid crystal module **302** includes a number of display units (i.e., pixels representing the primary colors), each of which includes a pixel electrode (not shown) and a pixel switching thin-film transistor **305** that is connected to the pixel electrode. Also arranged adjacent to each set of color display pixels that is made up of display units representing the three primary colors of RGB is a photosensor section including a thin-film diode **306.** Alternatively, a single photosensor section may be provided for two adjacent sets of color display pixels (consisting of six display units). Although not shown in FIG. **4**, the photosensor section includes not only the thin-film diode **306** but also at least one more thin-film diode that is connected in parallel with the former thin-film diode **306.** Using these thin-film diodes, the photosensor section senses externally incident light (i.e., visible radiation) **304.**

Although not shown in FIG. **4**, either, color filters are arranged closer to the viewer over each display unit but not over any photosensor section. An opaque layer **307** is arranged between the thin-film diodes **306** and the backlight **301**. Thus, the light that has come from the backlight **301** is cut off by the opaque layer **307** and not incident on any thin-film diode **306** through the back surface (i.e., through the rear substrate **314)**. It should be noted that the opaque layer **307** has only to be arranged so that the light that has come from the backlight **301** does not enter the intrinsic region of any thin-film diode **306.**

FIG. **5** is a schematic plan view illustrating the rear substrate of the display device of this embodiment. In the example illustrated in FIG. **5**, one photosensor section is provided for two sets of color display pixels, each set of which consists of R, G and B pixels.

The rear substrate of this preferred embodiment includes R, G and B pixels that are arranged to form a matrix pattern and multiple photosensor sections **700**. Each of those pixels includes a pixel switching thin-film transistor **705** and a pixel electrode (not shown). In this example, each set **709a, 709b** consisting of R, G and B pixels that are adjacent to each other will be referred to herein as a "set of color display pixels". In this embodiment, one photosensor section **700** is provided for two adjacent sets of color display pixels **709a** and **709b.**

The thin-film transistor **705** has its source region connected to a pixel source bus line **11** and its drain region connected to a pixel electrode, respectively. The thin-film transistor **705** is turned ON and OFF in response to a signal supplied from a pixel gate bus line **706**. Thus, a voltage is applied to the liquid crystal layer using the pixel electrode and a counter electrode, which is arranged on the front substrate that faces the rear substrate, thereby changing the alignment state of the liquid crystal layer and conducting a display operation.

In this embodiment, an RST signal line (which will also be referred to herein as a "reset line") **15** and an RWS signal line (which will also be referred to herein as a "read write line") **17** are arranged between two adjacent gate bus lines **706.** These lines **15** and **17** are made of the same layer as the gate bus lines **706**. And the photosensor sections **700** are arranged between those two lines **15** and **17**.

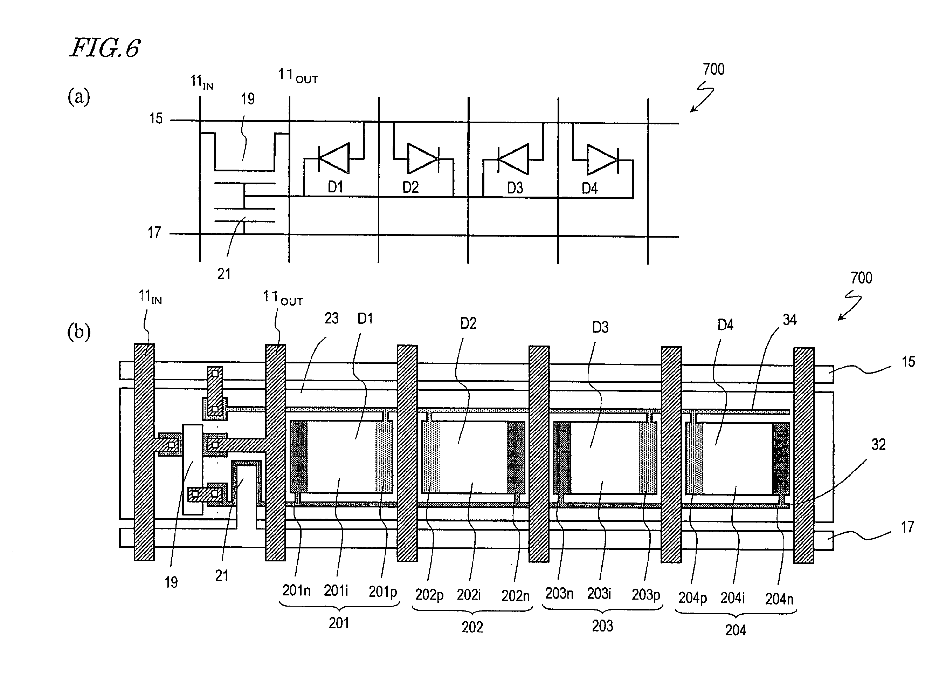

FIGS. **6(a)** and **6(b)** are respectively a circuit diagram and a plan view illustrating a configuration for a photosensor section according to this embodiment.

As shown in FIG. **6(a)****,** the photosensor section **700** includes four photosensor thin-film diodes **D1** through **D4**, a signal storage capacitor (Cs) **21** and a signal amplifying thin-film transistor (AMP) **19**. The thin-film diodes **D1** through **D4** are connected in parallel with each other. The thin-film diodes **D1** through **D4** and the thin-film transistor **19** are arranged within an area that is defined by source bus lines **11**, the RWS signal line **17** and the RST signal line **15**.

As shown in FIG. **6(b)**, the thin-film diode **D1** includes a semiconductor layer **201** in which an N-type region **201n**, an intrinsic region **201i** and a P-type region **201p** are arranged in this order in the X direction that is parallel to rows of pixels. The thin-film diode **D2** includes a semiconductor layer **202** in which a P-type region **202p**, an intrinsic region **202i** and an N-type region **202n** are arranged in this order in the X direction. The thin-film diode **D3** includes a semiconductor layer **203** in which an N-type region **203n,** an intrinsic region **203i** and a P-type region **203p** are arranged in this order in the X direction. And the thin-film diode **D4** includes a semiconductor layer **204** in which a P-type region **204p,** an intrinsic region **204i** and an N-type region **204n** are arranged in this order in the X direction. Therefore, the thin-film diodes **D1** and **D3** are TFDs of the first type, and the thin-film diodes **D2** and **D4** are TFDs of the second type.

In this embodiment, thin-film diodes of two different types are alternately arranged in line (i.e., in one direction). The P-type region **201p** of the semiconductor layer **201** faces the P-type region **202p** of its adjacent semiconductor layer **202**. In the same way, the respective N-type regions of the semiconductor layers **202** and **203** face each other, so do the respective P-type regions of the semiconductor layers **203** and **204.** In this embodiment, all of these semiconductor layers **201** and **204** are formed by patterning the same semiconductor film (e.g., a crystalline Si film).

The signal storage capacitor **21** is formed by using a gate electrode layer and a semiconductor layer (which is made of crystalline **S**i in this example) as its electrodes, and has its capacitance formed by a gate insulating film.

The respective P-type regions **201p** through **204p** of the thin-film diodes **D1** through **D4** are electrically connected together with a line **34**, which is made of a semiconductor and which is connected to the RST signal line **15.** The respective N-type regions **201n** through **204n** of the thin-film diodes **D1** through **D4** are electrically connected together with a line **32,** which is also made of a semiconductor. The line **32** is connected to the lower electrode (which is a part of the crystalline Si layer) of the signal storage capacitor **21** and is also connected to the RWS signal line **17** via that capacitor **21**. The line **32** is further connected to the gate electrode layer of the signal amplifying thin-film transistor **19**, which has its source region connected to an input signal line **11_{IN}** and its drain region connected to an output signal line **11**_{OUT}, respectively. These signal lines **11**_{IN}, and **11_{OUT}** are also used as source bus lines.

Next, it will be described how this photosensor section **700** performs its photosensing operation.

(1) First of all, an RWS signal is written on the signal storage capacitor **21** through the RWS signal line **17**. As a result, a positive electric field is generated in the n-type regions **201n** through **204n** of the thin-film diodes **D1** through **D4** and a reverse bias state is produced with respect to the thin-film diodes **D1** through **D4.**

(2) When optical leakage current flows through at least one of the thin-film diodes **D1** through **D4**, electric charge moves toward the RST signal line 15 by way of that thin-film diode.

(3) As a result, the potential level decreases on the n side of the N-type regions **201n** through **204n,** and that potential level variation changes the gate voltage being applied to the signal amplifying thin-film transistor **19.**

(4) A VDD signal is being applied to the source of the signal amplifying thin-film transistor **19** through the input signal line **11_{IN}.** If the gate voltage varies as described above, the value of the current flowing toward the output signal line **11**_{OUT} that is connected to its drain changes. As a result, that electrical signal can be output through the output signal line **11**_{OUT}.

(5) After that, forward current is made to flow through the output signal line **11_{OUT}** toward the thin-film diodes **D1** through **D4**, thereby writing an RST signal on the signal storage capacitor **21** and resetting the potential at the signal storage capacitor **21**.

By performing this series of operations (1) through (5) over and over again while making a scan, photosensing can get done using external light.

The semiconductor device of this embodiment includes a plurality of thin-film diodes **D1** through **D4,** the respective photosensor sections of which are connected in parallel with each other. Two of those thin-film diodes **D1** through **D4** are TFDs of the first type, and the other two are TFDs of the second type. That is why in the manufacturing process to be described later, the variation in the length of the intrinsic region due to misalignment can be canceled between the first and second types of TFDs. Consequently, the photocurrent characteristic of the photosensor section can be stabilized in spite of the misalignment.

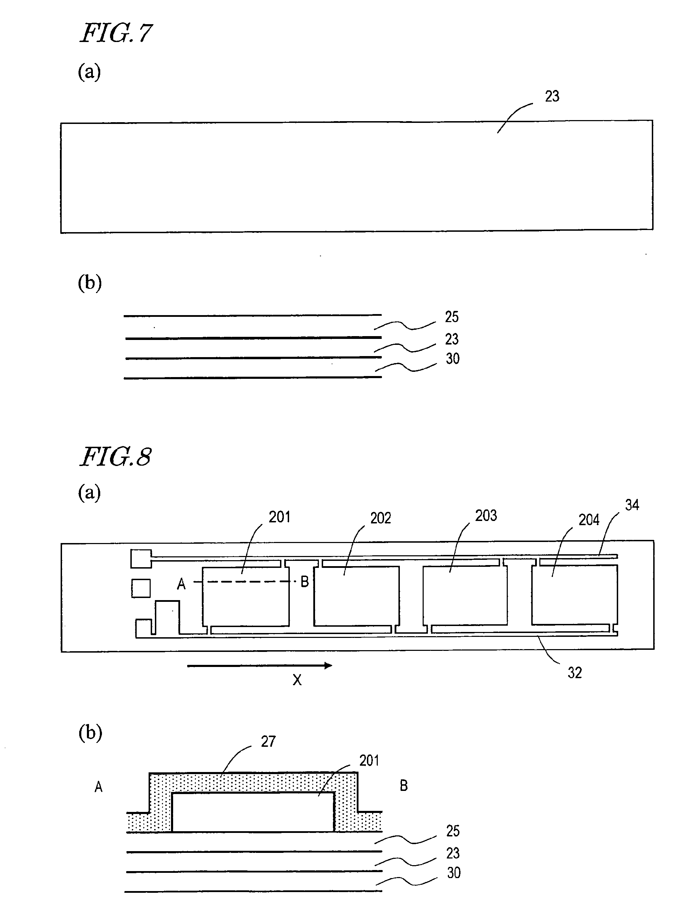

Hereinafter, it will be described how to fabricate the semiconductor device of this embodiment. FIGS. 7 through 12 are schematic representations illustrating an exemplary method for fabricating the semiconductor device of this embodiment. Portion **(a)** of each of these drawings is a plan view illustrating one photosensor section of the semiconductor device, while portion **(b)** thereof is a cross-sectional view illustrating a part of the photosensor section.

First of all, as shown in FIGS. **7(a)** and **7(b)**, the pattern of an opaque layer **23** is formed on a substrate **30**, and then an insulating film **25** is deposited thereon as an undercoat film. The opaque layer **23** may be formed out of either a metal film or a silicon film. If a metal film is used, some refractory metal such as tantalum (Ta), tungsten (W) or molybdenum (Mo) may be used in view of the heat treatment to be carried out later in the manufacturing process.

Next, as shown in FIGS. **8(a)** and **8(b)****,** a semiconductor film (such as a crystalline Si film) is stacked on the insulating film **25** and then patterned, thereby forming semiconductor layers **201** through **204** and lines **32** and **34** that connect them together. Next, a gate insulating film **27** is deposited over the semiconductor layers **201** through **204** and the lines **32** and **34.** The semiconductor film can be obtained by depositing an amorphous Si film by a known process such as a plasma CVD process or a sputtering process and then crystallizing the amorphous Si film. The semiconductor film may have a thickness of 10 nm to 100 nm. In this example, each of these semiconductor layers **201** through **204** has a square shape with a width of 30 *µ*m and a length (as measured in the X direction) of 30 *µ*m.

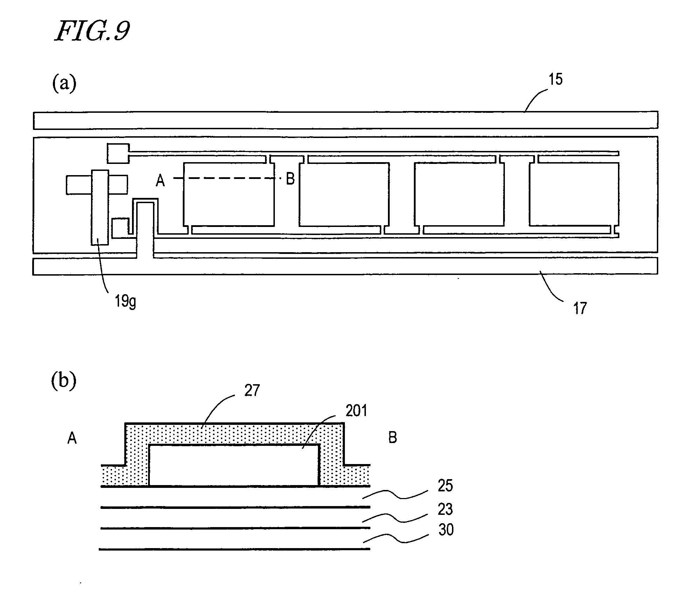

Subsequently, as shown in FIGS. **9(a)** and **9(b)**, a conductor film to make gate lines is deposited and then patterned, thereby forming a gate electrode **19g** for a thin-film transistor **19**, an RST signal line **15** and an RWS signal line **17.**

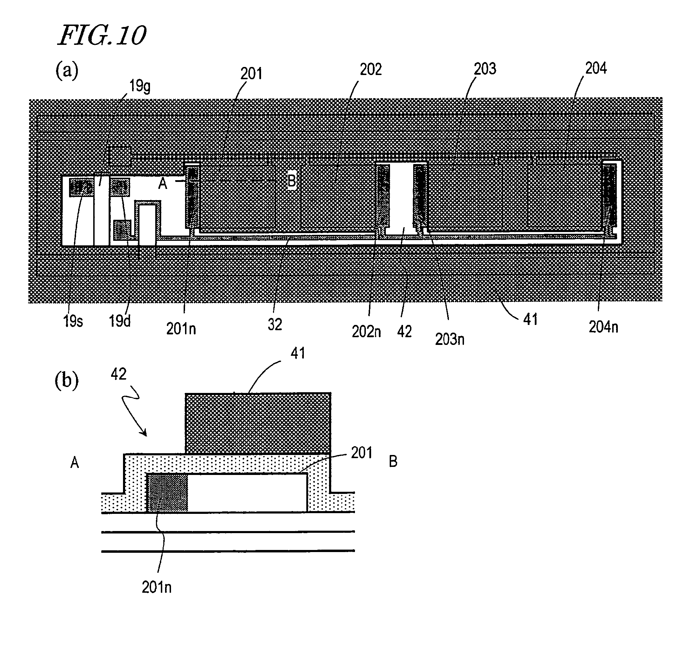

Thereafter, as shown in FIGS. **10(a)** and **10(b)**, a doping mask **41** of photoresist is formed on the gate insulating film **27**. The doping mask **41** has an opening **42** that exposes respective portions of the semiconductor layers **201** through **204** to be N-type regions, the line **32** and the semiconductor layer of the thin-film transistor **19.** The doping mask **41** is formed by performing exposure and development processes using a first photomask (not shown).

In such a state, ions of an N-type dopant (such as phosphorus ions) are implanted into the exposed portions of the semiconductor layers **201** through **204**, the line **32** and a portion of the semiconductor layer of the thin-film transistor **19** that is not hidden behind the gate electrode. As a result, N-type regions **201n** through **204n** are defined in the semiconductor layers **201** through **204,** respectively, and source/drain regions **19s** and **19d** are defined in the semiconductor layer of the thin-film transistor **19.**

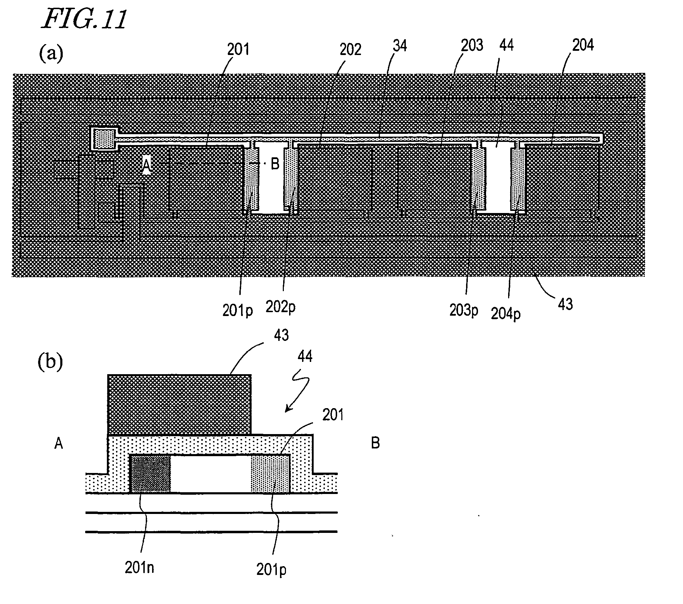

Subsequently, as shown in FIGS. **11(a)** and **11(b)****,** another doping mask **43** of photoresist is formed on the gate insulating film **27.** The doping mask **43** has an opening **44** that exposes respective portions of the semiconductor layers **201** through **204** to be P-type regions and the line **34**. The doping mask **43** is formed by performing exposure and development processes using a second photomask (not shown). The exposure system used in this process step is different from the one that has been used in the exposure process to define the N-type regions.

In such a state, ions of a P-type dopant (such as boron ions) are implanted into the exposed portions of the semiconductor layers **201** through **204** and the line **34.** As a result, P-type regions **201p** through **204p** are defined in the semiconductor layers **201** through **204,** respectively.

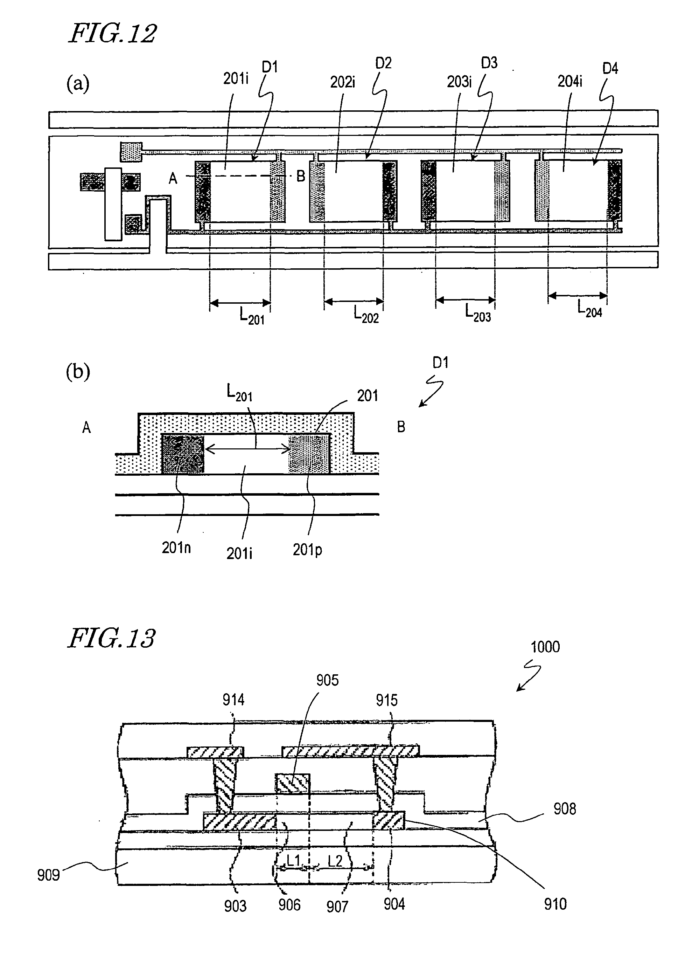

In this manner, thin-film diodes **D1** through **D4** are obtained as shown in FIGS. **12 (a)** and **12 (b)** . In the respective semiconductor layers **201** through **204** of these thin-film diodes **D1** through **D4,** the regions interposed between the N- and P-type regions become intrinsic regions **201i** through **204i**. The respective lengths **L₂₀₁** through L**₂₀₄** of the intrinsic regions **201i** through **204i** as measured in the X direction may be greater or smaller than the designed value (of 8 *µ*m, for example) according to the degree of misalignment between the first and second photomasks and the substrate **30.** However, even if misalignment occurred between the first photomask and the substrate **30** or between the second photomask and the substrate **30**, misalignment of the same magnitude should have occurred in the semiconductor layers **201** and **203** and in the semiconductor layers **202** and **204** in two opposite directions. Consequently, the variation in photocurrent characteristic that could be caused if lengths **L₂₀₁** through **L₂₀₄** varied owing to the misalignment can be substantially eliminated. That is to say, the variation in photocurrent characteristic is actually caused by only a variation (of 0.3 or less, for example) in lengths **L₂₀₁** through L**₂₀₄** due to the dimensional error during the exposure process shown in FIGS. **11** and **12****,** and therefore, can be reduced significantly compared to the known one.

In the embodiment described above, the photosensor section is comprised of four thin-film diodes. However, the photosensor section just needs to have at least one thin-film diode of one type and at least one thin-film diode of a different type, and the number of thin-film diodes to use is not particularly limited. Nevertheless, it would be beneficial if the number of TFDs of the first type to use is the same as that of TFDs of the second type to use as in this embodiment, because the variation in photocurrent characteristic due to the misalignment can be reduced even more effectively in that case. Furthermore, the thin-film diodes do not have to be arranged as shown in FIG. **6** but may have its arrangement modified appropriately as shown in FIG. **3**.

In the touchscreen panel LCD of this embodiment, the rear substrate does not have to have the configuration shown in FIG. **5**. For example, a storage capacitor **Cs** may be provided for each pixel switching TFT. Also, although one photosensor section is provided for two sets of color display pixels (each consisting of RGB pixels) in the example illustrated in FIG. 5, one photosensor section may be provided for each set of color display pixels as well. Alternatively, to further increase the resolution, one photosensor section could be provided for each of the RGB pixels. In that case, however, the aperture ratio would decrease significantly, and therefore, brightness on the screen could decrease.

The semiconductor device of the present invention does not have to be implemented as a touchscreen panel LCD but may also be a display device with an image sensor or fingerprint sensor function. That is to say, the photosensor section 700 described above may also be used as an image sensor or a fingerprint sensor. In that case, however, the semiconductor device needs to detect an image or a fingerprint being pressed against the screen, and therefore, generally needs to have higher resolution than a touchscreen sensor. The larger the number of photosensor sections provided for pixels, the higher the resolution gets. That is why the number of photosensor sections to provide may be adjusted appropriately according to the intended use. Still alternatively, color filters may be arranged closer to the viewer than the photosensor sections are, and the light that has been transmitted through the color filters may be received at the photosensor sections to make the photosensor sections function as color image sensors.

The configuration of such an image sensor to which the present invention is applied will be stated briefly.

The image sensor includes a number of photosensitive sections that are arranged two-dimensionally and an image information generating section that generates image information. Each of those photosensitive sections may have the same configuration as the display section (i.e., pixel) shown in FIG. 5. Alternatively, each photosensitive section may also consist of three pixels (which are RGB pixels). Each photosensitive section includes the photosensor section **700** described above. The image information generating section generates image information that is associated with the sensing signal that has been generated by the photosensor section **700** of each photosensitive section and the position of the photosensitive section. In this manner, the image that has been scanned by the image sensor can be generated or authenticated.

### INDUSTRIAL APPLICABILITY

The present invention has a broad variety of applications and is applicable to any kind of semiconductor device with thin-film diodes and to an electronic device in any field that uses such a semiconductor device. For example, the present invention is applicable to a CMOS circuit and a pixel section in an active-matrix-addressed liquid crystal display device and an organic EL display device. Such a display device may be used as either the display screen of a mobile phone or a portable game console or the monitor of a digital camera. Consequently, the present invention is applicable to any kind of electronic device including a built-in LCD or organic EL display device.

The present invention can be used particularly effectively in a display device such as an active-matrix-addressed LCD or an organic EL display device, an image sensor, a photosensor, and an electronic device including any of these devices in combination. It would be particularly beneficial to apply the present invention to a display device with a photosensor function that uses TFDs such as a touchscreen panel type display device.

### REFERENCE SIGNS LIST

- **1A, 1B, 1C, 1D**: N-type region
- **3A, 3B, 3C, 3D**: P-type region
- **5A, 5B, 5C, 5D**: intrinsic region
- **10A, 10B, 10C, 10D**: semiconductor layer
- **11**: source bus line
- **15**: RTS signal line
- **17**: RWS signal line
- **19**: signal-amplifying thin-film transistor
- **21**: signal-storage capacitor
- **23**: opaque layer
- **27**: gate insulating film
- **32, 34**: line
- **41, 43**: resist mask (doping mask)
- **42, 44**: opening of resist mask
- **100A, 100B**: thin-film diode
- **D1, D2, D3, D4**: thin-film diode
- **201n, 202n, 203n, 204n**: N-type region
- **201p, 202p, 203p, 204p**: P-type region
- **201i, 202i, 203i, 204i**: intrinsic region
- **201, 202, 203, 204**: semiconductor layer
- **700**: photosensor section

## Claims

1. A semiconductor device comprising:
a substrate; and
a plurality of thin-film diodes which are supported by the substrate and electrically connected in parallel with each other and each of which includes a semiconductor layer that has a P-type region, an N-type region, and an intrinsic region arranged between the P- and N-type regions,
wherein the thin-film diodes include
at least one thin-film diode of a first type, of which the semiconductor layer has the N-type region, the intrinsic region, and the P-type region that are arranged in this order in a first direction within a plane that is parallel to the substrate, and
at least one thin-film diode of a second type, of which the semiconductor layer has the P-type region, the intrinsic region, and the N-type region that are arranged in this order in the first direction.

2. The semiconductor device of claim 1, wherein the semiconductor layer of at least one of the thin-film diodes is arranged adjacent to the semiconductor layer of another thin-film diode of a different type, and
wherein either the respective N-type regions or the respective P-type regions of the semiconductor layers of the at least one thin-film diode and that another thin-film diode face each other.

3. The semiconductor device of claim 1 or 2, wherein the thin-film diodes include 2n thin-film diodes (where n is a positive integer), and
wherein n of those 2n thin-film diodes are the first type of thin-film diodes, and the other n thin-film diodes have the semiconductor layer of the second type of thin-film diodes.

4. The semiconductor device of claim 3, wherein the respective semiconductor layers of the 2n thin-film diodes are arranged so that either the respective N-type regions or the respective P-type regions of two adjacent one of the semiconductor layers face each other.

5. The semiconductor device of one of claims 1 to 4, wherein none of the thin-film diodes have a gate electrode.

6. A method for fabricating the semiconductor device of one of claims 1 to 5, the method comprising the steps of:
forming a plurality of semiconductor layers as semiconductor islands on the substrate;
defining a first resist mask so that the first resist mask covers portions of each said semiconductor island to be N-type and intrinsic regions but exposes the other portion of the semiconductor island to be a P-type region, and implanting ions of a P-type dopant into that portion of each said semiconductor island that is not covered with the first resist mask, thereby defining a P-type region there; and
defining a second resist mask so that the second resist mask covers portions of each said semiconductor island to be P-type and intrinsic regions but exposes the other portion of the semiconductor island to be an N-type region, and implanting ions of an N-type dopant into that portion of each said semiconductor island that is not covered with the second resist mask, thereby defining an N-type region there,
wherein the region of each said semiconductor island that is located between the N- and P-type regions becomes an intrinsic region.
